# EUROPEAN PATENT APPLICATION

(11) **EP 4 782 845 A1**
(43) Date of publication of application: **29.07.2026**
(21) Application number: 26154473.8
(22) Date of filing: 27.01.2026
(51) Int. Cl.: G01R 1/00

(54) **SYSTEM AND METHOD FOR SIMULATION OF CHARACTERISTIC ARTIFICIAL INTELLIGENCE (AI) LOAD CONDITIONS**

(30) Priority: 28.01.2025 US 202563750469 P; 19.01.2026 US 202619452609
(71) Applicant: Vertiv International GmbH, 8212 Neuhausen am Rheinfall (CH)
(72) Inventor: DI FILIPPI, Arturo, Neuhausen am Rheinfall (CH); BALMA, Luigi, Neuhausen am Rheinfall (CH); GALUPPI, Graziano, Neuhausen am Rheinfall (CH)
(74) Representative: Beal, James Michael

(57) **Abstract**

The present disclosure is directed to devices for monitoring operating power distributed to information technology (IT) devices under particular operating conditions. One or more devices under test (DUT), e.g., data center components, are provided between a power source and a resistive load. Between the DUT and resistive load are provided one or more static switches and a controller. According to a desired load profile defined by parameters which may be set by a user or predetermined to match specific high-performance applications, the controller generates a load pattern including one or more pulsing trains simulating a pulsing current load characteristic of artificial intelligence (AI) or other high-performance applications. The controller drives the static switches to reproduce the load pattern so that the reactions of devices under test to the desired profile may be observed.

## Description

The present application claims the benefit under 35 U.S.C. § 119(e) of U.S. Provisional Patent Application Serial Number 63/750,469 filed January 28, 2025 and U.S. Non-Provisional Patent Application Serial Number 19/452,609 filed January 19, 2026.

### TECHNICAL FIELD

The present disclosure is directed to devices for monitoring operating power distributed to information technology (IT) devices under particular operating conditions.

### BACKGROUND

Artificial intelligence (AI), machine learning (ML), large language models (LLM), generative AI, and other similar high-performance computing (HPC) applications require the development of dedicated server racks incorporating highly powerful central processing units (CPU) and/or graphic processing units (GPU). For example, these dedicated processors train parameters (based on, e.g., massive quantities of real or simulated training data) which then, given a new dataset, learn, infer, or predict an appropriate (e.g., most likely) outcome. To this end, HPC/AI training and inference may require driving large numbers of CPUs or GPUs working in unison to fulfill a particular workload. Entire racks, rows, rooms, or even entire data centers may synchronize all of their component units for workload processing.

Further, the operating power required for these synchronized and/or high-performance applications is associated with characteristic load profiles which present significant and diverse challenges for power demand and power density as well as thermal management of the increased amounts of heat generated by workload processing. For example, HPC/AI loads are associated with massive and rapidly changing power demands that may repeat for several minutes or several hours. Power demands may overload power distribution capacity, e.g., as high as 150 percent, resulting in voltage sags that may trigger a switch to backup power equipment. These switches may in turn increase battery discharge and recharge cycles, reducing the lifespan of backup batteries. Rapid power fluctuations as well as voltage and frequency oscillations may lead to power quality and stability issues, and the higher power density required may in turn require higher voltages. Liquid cooling systems have very low thermal inertia, such that they may need to run continuously to keep up with heat dispersal. Monitoring and measurement equipment may be unable to meaningfully characterize highly dynamic HPC/AI load profiles. Further, as the characteristics of HPC/AI load profiles are not yet well understood, there is as yet no viable means of testing the ability of data center infrastructure configurations to handle HPC/AI workload processing.

### SUMMARY

In a first aspect, a system for simulating pulsing load conditions characteristic of HPC/AI workload processing is disclosed. In embodiments, the system may include a device under test (DUT) installable between a power source and a resistive load (e.g., that may determine a peak level of operating power provided by the power source and flowing through the DUT. The system may further include a static switch installable between the DUT and the resistive load. The system may further include a user interface for receiving control input from a user, e.g., based on a desired load profile and/or load conditions to be simulated. For example, the load profile may include a pulsing train comprising a sequence of "on" stages, where the current between the DUT and resistive load is at or near maximum, alternating with "off" stages, where the current between the DUT and resistive load is near minimum. The provided control input may include control parameters, e.g., an ON duration for each "on" stage and an OFF duration for each "off" stage. The system may further include a controller configured for generating a load pattern based on the provided control input, and for driving the static switch to reproduce the load pattern.

In some embodiments, the ON duration and/or OFF duration may be based on a count of voltage phase periods comprising the respective "on" or "off" stages.

In some embodiments, each pulsing train may be followed by a non-pulsing train wherein the current between the DUT and the resistive load is substantially zero. Similarly, the control parameters may include an "on" duration for each pulsing train and an "off" direction for each non-pulsing train.

In some embodiments, the controller may determine a maximum peak power level for the load pattern.

In some embodiments, the maximum peak power level may include a sequence of peaks.

In some embodiments, the DUT may include an uninterruptible power supply (UPS) and/or a power distribution unit (PDU).

In some embodiments, the DUT may be associated with a data center environment, and may include a cooling system for thermal management of the environment.

In some embodiments, the controller may include a memory for storage of customized load profiles, e.g., whereby the user may via control input select a customized load profile.

In some embodiments, the control input may include adjustment of one or more control parameters of the selected customized load profile.

In some embodiments, the control input may include a user-determined value for one or more control parameters.

In some embodiments, the system may include a display unit for presenting to the user a waveform based on the generated load pattern and/or one or more control parameters of the load pattern.

In a further aspect, a method for simulation of pulsing load conditions characteristic of HPC/AI workload processing is disclosed. In embodiments, the method may include providing a power source, a resistive load, and a device under test (DUT) between the power source and resistive load. The method may include providing a static switch between the DUT and the resistive load. The method may include receiving control input from a user, where the control input is based on a desired load profile or set of load conditions including a pulsing train, e.g., a sequence of "on" stages (where the current between the DUT and resistive load is at or near maximum) alternating with "off" stages (where the current between the DUT and resistive load is at or near minimum). The control input may further include a set of control parameters, e.g., an ON duration for each "on" stage and an "off" duration for each "off" stage. The method may include generating a load pattern based on the control input. The method may include reproducing the generated load pattern by driving the static switch to switch the resistive load on and off.

In some embodiments, the ON duration and/or OFF duration may be based on a count of voltage phase periods during the respective "on" stage or "off" stage.

In some embodiments, the method may include determining a maximum peak power of the load pattern.

In some embodiments, each pulsing train may be followed by a non-pulsing train whereby the current between the DUT and resistive load is substantially zero. Similarly, the control input may include an ON duration for each pulsing train and an OFF duration for each non-pulsing train.

In some embodiments, the DUT may be associated with a data center environment and may include a cooling system for thermal management of said environment.

In some embodiments, the DUT may include an uninterruptible power supply (UPS) and/or a power distribution unit (PDU).

In some embodiments, the system controller may include a memory for storing customized load profiles. Accordingly, the control input may include selection of a customized load profile by the user.

In some embodiments, the control input may include an adjustment to one or more control parameters of a load profile (e.g., a selected customized load profile) or pattern based on a desired load profile.

In some embodiments, the method may further include presenting to the user, via a display unit of the system, a waveform based on the generated load pattern and/or a set of control parameters based on the desired load profile.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a block diagram of a system for HPC/AI load simulation within a data center environment (real or simulated) wherein operating power is delivered to information technology (IT) devices, according to exemplary embodiments of the inventive concepts disclosed herein;
FIG. 2 is a diagrammatic illustration of an exemplary HPC/AI load pattern;
FIG. 3 is a graphical representation of a characteristic HPC/AI load profile corresponding to the load pattern of FIG. 2;
FIG. 4 is an illustration of an exemplary user interface (UI) of the system for HPC/AI load simulation of FIG. 1;
FIG. 5 is a graphical illustration of timing parameters for the load profile and load pattern of FIGS. 2 and 3;
and FIG. 6 is a process flow diagram of a method for simulation of pulsing load conditions characteristic of HPC/AI loads according to the inventive concepts disclosed herein.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to a system and method for simulating HPC/AI load conditions. In particular, the system includes hardware and software components for reproducing load patterns including the rapid pulsing and/or fluctuation of load current characteristic of HPC/AI applications, e.g., generative AI, machine learning (ML), large language models (MLL), neural networks (NN). Switching equipment is then driven to reproduce the desired load pattern in a testing environment. Accordingly, any component within the data center environment subject to pulsing current loads may be tested and/or debugged. The load simulator may provide for efficient design and validation testing according to multiple real-world scenarios. Further, the load simulator may allow a user or tester to define aspects of the simulated load pattern, or select from customized load patterns tuned to specific applications and/or vendors (e.g., ChatGPT, DALL-E, Midjourney, Nvidia, OpenAI, Microsoft, Google/Alphabet, Meta).

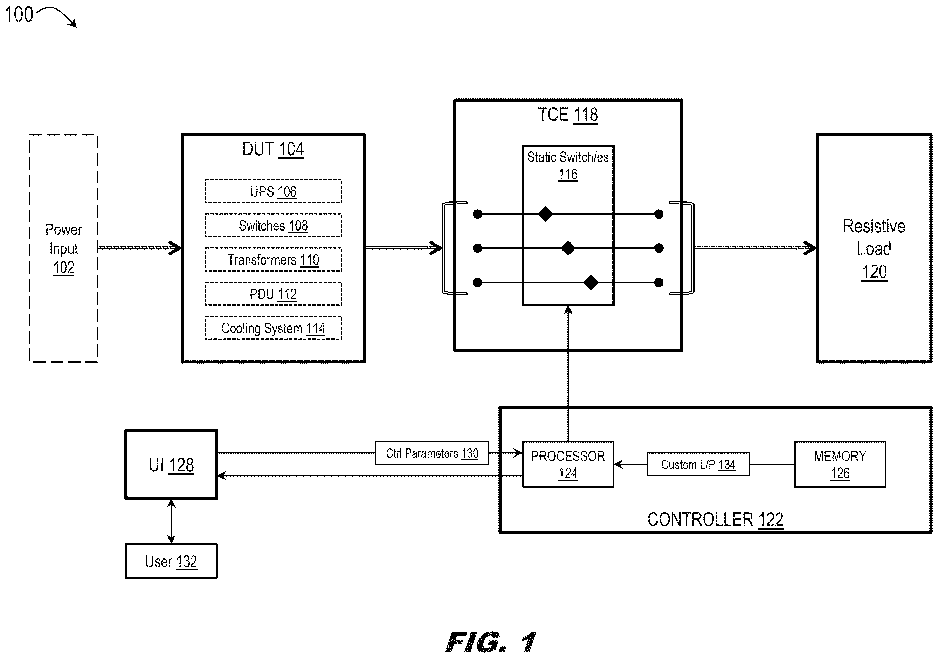

Referring now to FIG. 1, a system 100 for simulation of HPC/AI pulsing load characteristics and/or patterns is shown. The system 100 may include a power input 102; devices under test 104 (DUT; may include any or all of: uninterruptible power supply 106 (UPS); switches 108; transformers 110; power distribution unit 112; or cooling system 114); one or more static switches 116 within a top cable entry (TCE) environment 118 (TCE); resistive load 120; controller 122 (which may include processor/s 124 and memory 126); and user interface 128 (UI).

In embodiments, the system 100 generally may be placed between a power input 102 (e.g., power source) and a resistive load 120. For example, the resistive load 120 (e.g., simulated load) may determine the maximum peak of power flowing towards the device/s under test 104. Further, the components of the system 100 (the controller 122, static switch/es 116, and UI 128) may be disposed within the TCE 118 between the device/s under test 104 and the resistive load 120.

In embodiments, when validating or testing any device/s under test 104 subject to pulsing currents characteristic of HPC/AI loads, the controller 122 may drive the static switch/es 116 on and off to reproduce pulsing current conditions according to control parameters 130. For example, control parameters 130 defining a desired load profile or load pattern may be provided directly by a user 132 via the UI 128. In embodiments, a load profile (and a load pattern generated based on the load profile) may define a pulsing train wherein the current load between the DUT 104 and the resistive load 120 pulses, or fluctuates, between a maximum load and a minimum load. For example, these alternating stages of maximum load and minimum load may be referred to throughout this disclosure as "on" stages and "off" stages respectively.

In embodiments, control parameters 130 defining a load profile may include a first ON duration (e.g., duration of each "on" stage), and a first OFF duration (e.g., duration of each "off" stage). For example, the pulsing train may be characterized as a repeating sequence of pulses wherein each individual pulse consists of an "on" stage and a transition to the "off" stage, the number of pulses to be repeated alternating "on" and "off" stages (e.g., a first pulse consists of the "on" stage and a transition to the "off" stage, a second pulse consists of the "off" stage and a transition to the "on" stage). In some embodiments, the first ON duration may be characterized as a number of waveform periods at an input line frequency, e.g., 20 ms for a 50 Hz line.

In some embodiments, a load profile may further provide that the pulsing train alternates with a non-pulsing train, e.g., wherein substantially zero load current flows between the DUT 104 and the resistive load. For example, control parameters 130 may further include a second ON duration (e.g., pulsing duration), or a duration of the pulsing train, and a second OFF duration (e.g., non-pulsing duration), or a duration of the non-pulsing train.

In some embodiments, the controller 122 includes a memory 126 configured for storage of customized load profiles 134 (e.g., reference load profiles) designed to simulate specific HPC/AI applications and/or general characteristics associated with specific HPC/AI vendors. For example, customized load profiles 134 may include predetermined values for one or more of the above control parameters 130. In some embodiments, the user 132 may create bespoke load profiles by adjusting the control parameters 130 of a customized load profile 134, saving the bespoke load profiles to memory 126 as additional customized or reference load profiles. In some embodiments, the user 132 may select an arbitrary load profile by uploading or entering (e.g., via UI 128) a complete set of control parameters 130.

In embodiments, the controller 122 may generate a load pattern based on the desired load profile (e.g., whether said desired load profile is a user-defined load profile based entirely on control parameters 130 provided by the user 132, a customized load profile 134 retrieved from memory 126, or a customized load profile adjusted by the user). For example, the controller 122 may drive the static switch/es 116 on and off according to the generated load pattern to reproduce the desired load profile and/or load conditions.

In embodiments, the controller 122 may monitor the reproduced load pattern. For example, the UI 128 may include a display. For example, the UI 128 may present to the user 132 (e.g., graphically and/or textually) a waveform corresponding to the generated load pattern. In some embodiments, the UI 128 may present the current control parameters 130 to the user 132. For example, the user 132 may be able to further adjust one or more control parameters 130, and therefore the generated load pattern, via the UI 128. Further, as the generated load pattern is adjusted by the user 132, the waveform displayed to the user may change to reflect these adjustments. In some embodiments, the display may include a remotely located computing device (e.g., desktop and monitor, laptop, tablet) connected to the UI 128 via physical or wireless communications link.

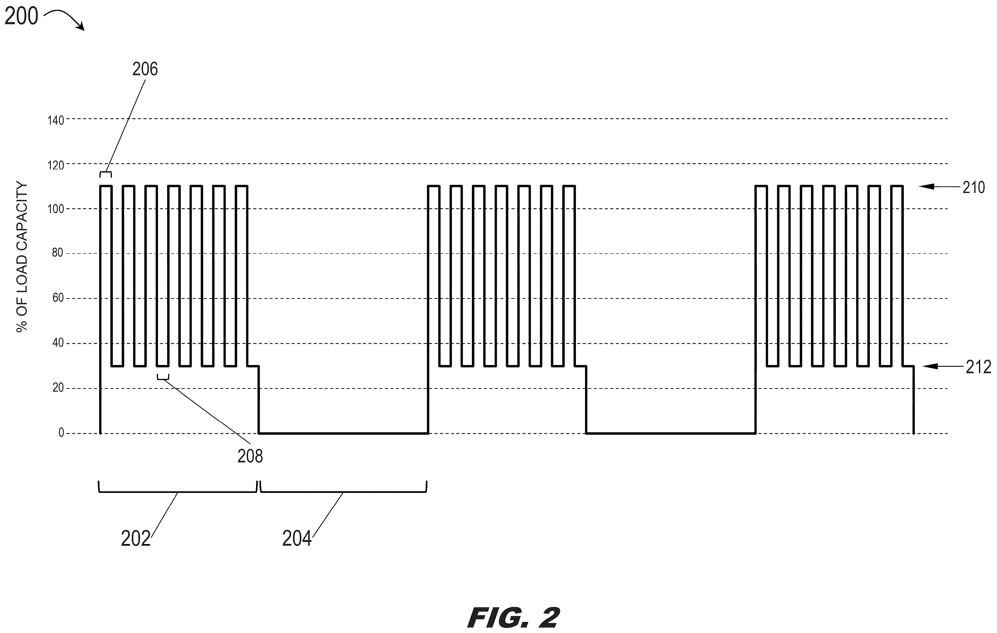

Referring now to FIG. 2, a waveform 200 characteristic of HPC/AI pulsing loads simulated by the system 100 of FIG. 1 is shown.

As represented by the waveform 200, HPC/AI loads may comprise a repeating series of pulsing trains 202 alternating with non-pulsing trains 204. For example, each pulsing train 202 may be characterized as a repeating sequence or series of pulses where each pulse includes an ON stage 206 followed by an OFF stage 208, the ON stage associated with a maximum load capacity 210 and the OFF stage associated with a minimum load capacity 212 respect to the current load flowing between the device/s under test 104 (see FIG. 1) and the resistive load 120 (see FIG. 1). It may further be noted that the maximum load capacity 210 associated with the ON stage 206 may meet or exceed the total load capacity (e.g., 100%) associated with the power input 102 (see FIG. 1), due to, e.g., synchronous workload processing by multiple CPUs and GPUs in a given rack, row, data center environment, etc. In embodiments, the pulsing train 202 may continue for anywhere between a few minutes to several hours, according to a generated load pattern based on, e.g., a customized load profile 134 (see FIG. 1) and/or user-defined control parameters 130 (FIG. 1) provided by a user 132 (see FIG. 1). As noted above, the pulsing trains 202 may alternate with non-pulsing trains 204, wherein substantially zero current flows between the device/s under test 104 and resistive load 120. For example, the duration of the non-pulsing train may also be defined by the customized load profile 134 and/or user-defined control parameters 130.

In embodiments, the waveform 200 and any related control parameters 130 may be presented to a user 132 graphically and/or textually via the UI 128 (see FIG. 1).

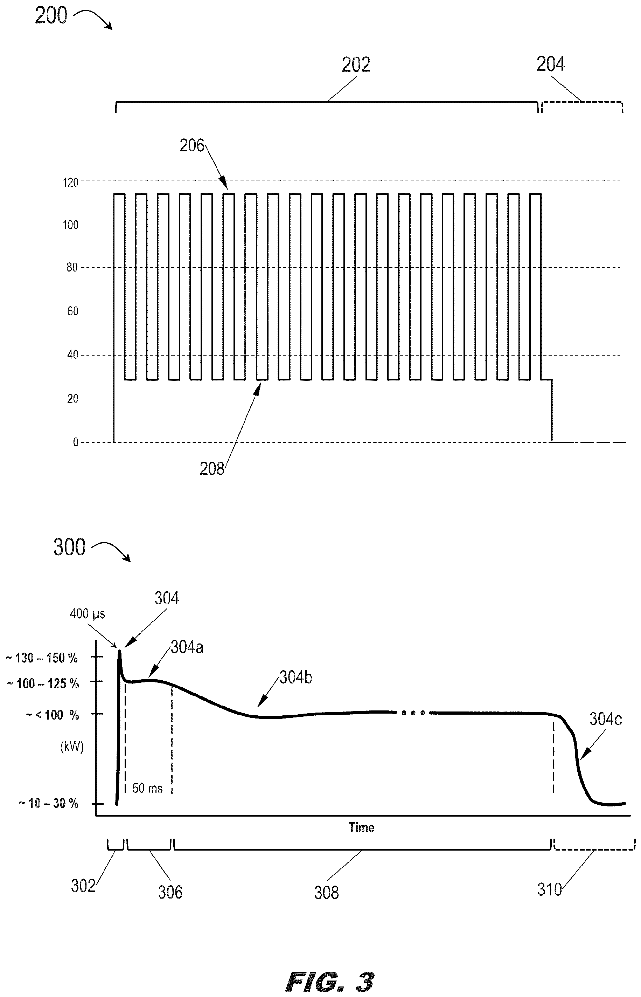

Referring now to FIG. 3, a detail of a single pulse of a pulsing train 202 of a load profile 300 corresponding to an HPC/AI pulsing load represented by the waveform 200 (see FIG. 2) is shown.

In embodiments, the highly dynamic nature of the waveform 200, particularly the rapid pulsing (ON stage 206, OFF stage 208) associated with the pulsing train 202, may complicate intuitive monitoring of the HPC/AI load. By way of a non-limiting example, the load profile 300 corresponding to the pulsing train 202 may comprise a series or sequence of phases. During an initial or power-up phase 302, the peak power 304 of each GPU (e.g., assuming a group of GPUs operating in unison) briefly (e.g., ~400 µs) may spike to a maximum peak power, e.g., ~130 to 150 percent of the GPU's power rating (kW). During a second or maximum-power phase 306, peak power 304a may briefly (e.g., ~50 ms) drop, e.g., to around ~100% to 125% of the GPU's power rating. Ultimately, over a third or average-power phase 308, peak power 304b may average out to the GPU's power rating (e.g., ~100%) over a longer duration of up to several seconds. Finally, during a fourth or idle phase 310, e.g., corresponding to a non-pulsing train 204 of defined or indeterminate duration, peak power 304c may level off at a fraction of the power rating, e.g., between ~ 10% and 30%.

As the pulsing train 202 continues during the average-power phase 308, peak power 304b may spike again or may hold at or around 100%. With respect to device/s under test 104 (see FIG. 1; or, for example the counterparts of said device/s in a real-world data center environment), the closer to the GPU these devices are (e.g., PDU 112 vs. UPS 106, see FIG. 1) the greater the impact of the overload conditions associated with the spiking peak power 304.

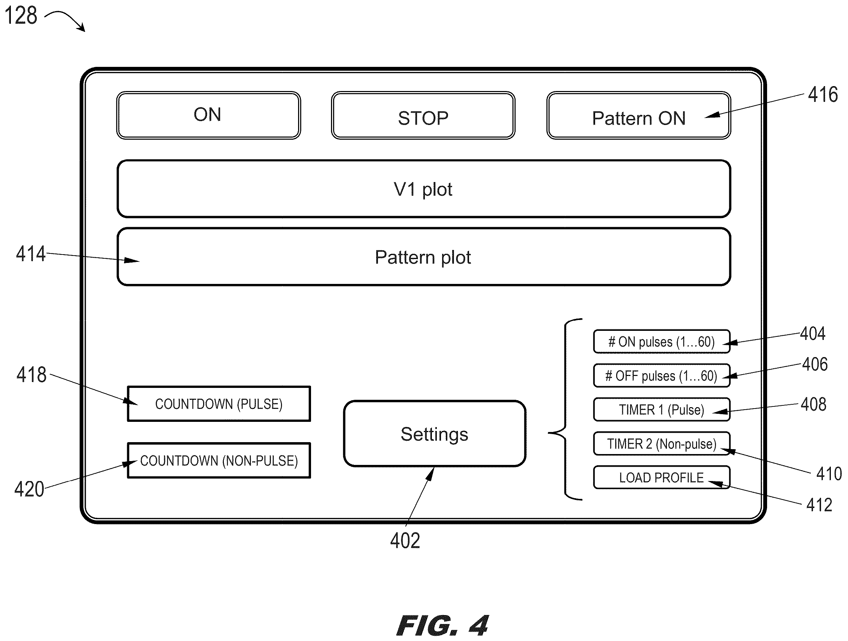

Referring now to FIG. 4, an exemplary UI 128 of the system 100 (see FIG. 1) is shown.

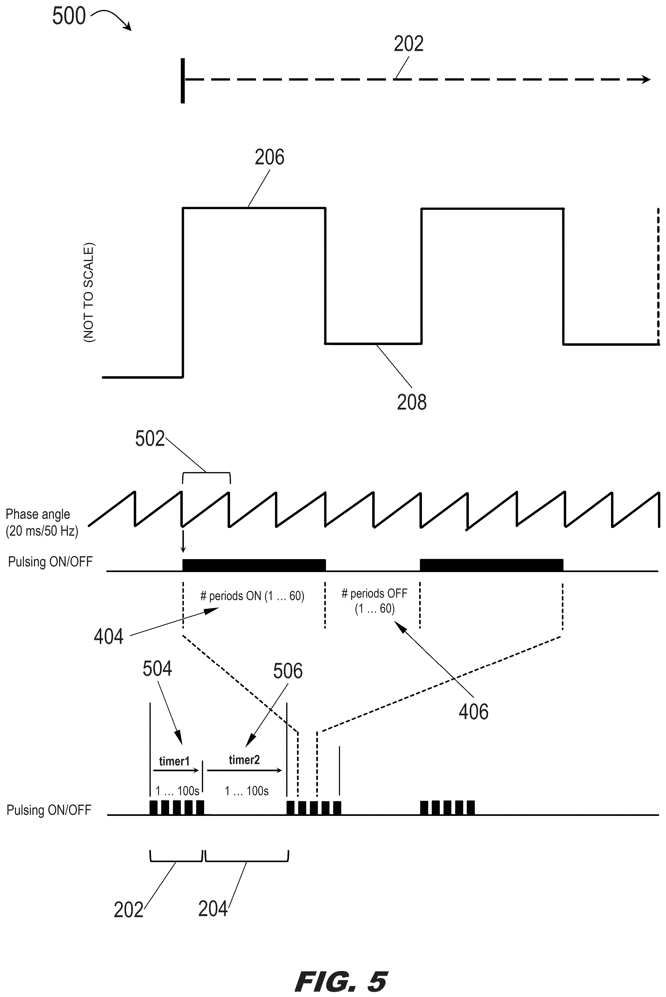

In embodiments, the UI 128 may include a touchscreen capable of presenting graphics and/or text to, and receiving control input from, the user 132 (see FIG. 1). For example, the UI 128 may include a window or display surface of a remotely located device communicatively connected (e.g., via physical or wireless network) to the system 100. In some embodiments, the UI 128 may include a non-reactive display surface and proximate controls (e.g., buttons, switches) for the entry of control input. For example, the UI 128 may include a settings menu 402, via which the user 132 may enter one or more of: a first ON duration 404 of each ON stage 206 (e.g., the number of voltage phase periods (see FIG. 5, below) to occur during each ON stage (see FIG. 2)); a first OFF duration 406 (e.g., the number of voltage phase periods to occur during each OFF stage (see FIG. 2)); a timer 408 corresponding to the second pulsing duration (e.g., duration of the pulsing train); and/or a timer 410 corresponding to the second non-pulsing duration (e.g., duration of the non-pulsing train). Further, the user may retrieve and view (412) customized load profiles 134 (see FIG. 1) for selection and implementation via the controller 122 (see FIG. 1) and static switch/es 116 (see FIG. 1).

In embodiments, when a desired load profile has been loaded (e.g., via user-provided control parameters 130 and/or customized load profiles 134) and a load pattern has been generated by the controller 122, the UI 128 may plot or display (414) the load pattern (and/or the corresponding control parameters) to the user 132 via the UI 128. Further, when the load pattern is implemented by the controller 122 and static switch/es 116 (e.g., upon activation (416) by the user 132), the UI 128 may display a timer 418 counting down to the end of the current pulsing train 202 (per the timer 408) and/or a timer 420 counting down to the end of the current non-pulsing train 204 (per the timer 410).

Referring now to FIG. 5, an exemplary load pattern 500 corresponding to a pulsing train 202 of the waveform 200 (see FIG. 2) is shown.

In embodiments, as noted above, the load pattern 500, and the desired load profile 300 (see FIG. 3) upon which the load pattern is based, may be defined by a set of control parameters 130 (see FIG. 1). For example, the pulsing train 202 may be defined as an alternating sequence of ON stages 206 and OFF stages 208. The duration of each ON stage 206 may be defined by a first ON duration 404, e.g., a number of line periods to stay ON, and the duration of each OFF stage 208 may be defined by a first OFF duration 406. In embodiments, both the first ON duration 404 and the first OFF duration 406 may be defined, e.g., either set by a user 132 (see FIG. 1) via the UI 128 (see FIG. 4) or by a customized load profile 134 (see FIG. 1), as a count of individual voltage phase periods 502. For example, assuming a 50 Hz line, each voltage phase period 502 may be set at 20 ms, such that when the first ON duration 404 is set to three (3) voltage phase periods, and the first OFF duration 406 is set to two (2) voltage phase periods, the first pulsing and non-pulsing durations would then be 60 ms and 40 ms respectively.

In embodiments, the control parameters 130 may further include timers defining the length of the pulsing train 202 as well as the non-pulsing train 204 following each pulsing train, e.g., separating each pulsing train of a repeating series or sequence thereof. For example, the second pulsing duration 504 (e.g., timer1) may define the duration of the pulsing train 202, while the second non-pulsing duration 506 may define the duration of the non-pulsing train 204, e.g., how far apart in time each pulsing train occurs. In embodiments, during each pulsing train 202, the controller 122 may drive the static switch/es 116 (see FIG. 1) on and off to simulate a pulsing current according to the load pattern 500.

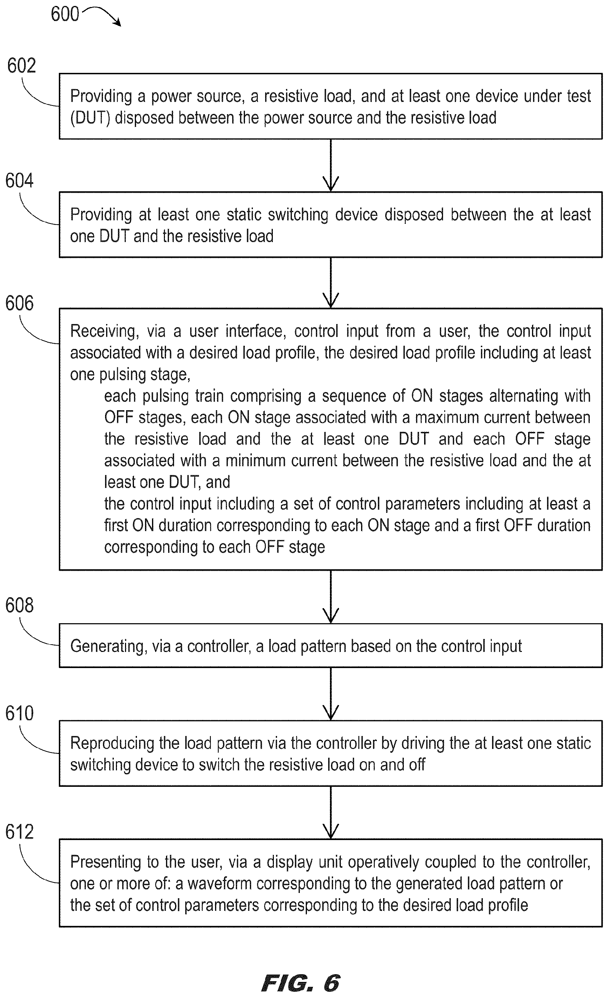

Referring now to FIG. 6, the method 600 may be implemented by the system 100 and may include the following steps.

At step 602, a power source (e.g., power input) and a resistive load are provided, and one or more devices under test (DUT) are provided between the power source and the resistive load. In some embodiments, devices under test may include one or more of power distribution units (PDU), uninterruptible power supplies (UPS), switches, transformers, or cooling delivery systems/components.

At step 604, one or more static switches are placed between the device/s under test and the resistive load.

At step 606, control input is provided by a user via a user interface (UI) of the system. In some embodiments, control input is associated with a desired load profile comprising a set of control parameters defining the durations of alternating pulsing and non-pulsing stages of a pulsing train (e.g., first pulsing and non-pulsing durations), as well as the overall duration of the pulsing train as well as a non-pulsing train separating pulsing trains (e.g., second pulsing and non-pulsing durations), wherein the resulting load profile corresponds to an alternating sequence of pulsing and non-pulsing trains. In some embodiments, the first pulsing and non-pulsing durations are defined by a count of individual voltage phase periods comprising both the pulsing and non-pulsing stages. For example, the voltage phase periods may be based on a phase angle of the line, and each pulsing stage may be set to M voltage phase periods and each non-pulsing stage set to N voltage phase periods (where M, N are positive integers).

At a step 608, the system controller generates a load pattern based on the desired load profile. In some embodiments, the load pattern is based entirely upon user-provided control parameters (e.g., first pulsing and non-pulsing durations, second pulsing and non-pulsing durations). In some embodiments, the load pattern is based on a customized load profile stored to memory and selected by the user to emulate a particular HPC/AI application or vendor. In some embodiments, the load pattern is based on an arbitrary load profile whereby one or more control parameters of a customized load profile are adjusted by the user, or where all parameters are entered or uploaded by the user.

At step 610, the system controller simulates the load pattern by driving the static switch/es on and off to reproduce HPC/AI characteristic pulsing current loads according to the control parameters of the desired load profile.

In some embodiments, the method 600 includes a further method step 612. At step 612, the system controller monitors the simulated load pattern and presents to a user (e.g., via graphic and/or textual display via the UI) a waveform corresponding to the current load pattern, e.g., a shape of the current flowing into the resistive load. In some embodiments, the UI additionally or alternatively displays the current control parameters.

### CONCLUSION

It is contemplated that embodiments of the inventive concepts disclosed herein may have numerous advantages. For example, as noted above, end users may be able to validate or test data center components (e.g., power delivery, power distribution, thermal management) in multiple configurations against simulated HPC-AI conditions. Some customers may be interested in testing devices made not only by VERTIV to validate them for their specific application.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true scope of the subject matter described herein. Furthermore, it is to be understood that the invention is defined by the appended claims.
The disclosure comprises the following items:
1. A system for pulsing load simulation, comprising:
   at least one device under test (DUT) installable between a power source and a resistive load;
   at least one static switching device installable between the at least one DUT and the resistive load;
   a user interface configured to receive from a user control input associated with a desired load profile,
      the desired load profile including at least one pulsing train, each pulsing train comprising a sequence of ON stages alternating with OFF stages, each ON stage associated with a maximum current between the resistive load and the at least one DUT and each OFF stage associated with a minimum current between the resistive load and the at least one DUT,
         and
      the control input including a set of control parameters including at least a first ON duration corresponding to each ON stage and a first OFF duration corresponding to each OFF stage;
         and
   a controller including at least one processor and configured to:
      generate a load pattern based on the control input;
         and
      drive the at least one static switching device to reproduce the load pattern.
2. The system of item 1, wherein at least one of the first ON duration or the first OFF duration is associated with a count of voltage phase periods comprising the first ON duration or first OFF duration.
3. The system of item 1 or item 2, wherein:
   each pulsing train is followed by a non-pulsing train associated with zero current between the resistive load and the at least one DUT,
      and
   wherein the set of control parameters includes:
      a second ON duration corresponding to each pulsing train;
         and
      a second OFF duration corresponding to each non-pulsing train.
4. The system of any preceding item, wherein the controller is configured to determine at least one peak of power associated with the load pattern.
5. The system of any preceding item, wherein the at least one peak includes a sequence of peaks.
6. The system of any preceding item, wherein the at least one DUT includes at least one of an uninterruptible power supply (UPS) or a power distribution unit (PDU).
7. The system of any preceding item, wherein the at least one DUT is associated with a data center environment and includes a cooling system configured for thermal management of the data center environment.
8. The system of any preceding item, wherein the controller further includes a memory configured for storage of a plurality of customized load profiles;
   and
   wherein the control input corresponds to a selection of the desired load profile from among the plurality of customized load profiles.
9. The system of any preceding item, wherein the control input includes at least one adjustment of a control parameter corresponding to the selected customized load profile.
10. The system of any preceding item, wherein the control input includes at least one control parameter set by the user.
11. The system of any preceding item, further comprising:
   at least one display unit operatively coupled to the controller, the at least one display unit configured to present to the user one or more of:
   a waveform corresponding to the generated load pattern;
      or
   a control parameter corresponding to the generated load pattern.
12. A method for pulsing load simulation, the method comprising:
   providing a power source, a resistive load, and at least one device under test (DUT) disposed between the power source and the resistive load;
   providing at least one static switching device disposed between the at least one DUT and the resistive load;
   receiving, via a user interface, control input from a user, the control input associated with a desired load profile, the desired load profile including at least one pulsing train,
      each pulsing train comprising a sequence of ON stages alternating with OFF stages, each ON stage associated with a maximum current between the resistive load and the at least one DUT and each OFF stage associated with a minimum current between the resistive load and the at least one DUT,
         and
      the control input including a set of control parameters including at least a first ON duration corresponding to each ON stage and a first OFF duration corresponding to each OFF stage;
   generating, via a controller, a load pattern based on the control input; and
   reproducing the load pattern via the controller by driving the at least one static switching device to switch the resistive load on and off.
13. The method of item 12, wherein at least one of the first ON duration or the first OFF duration is associated with a count of voltage phase periods comprising the first ON duration or first OFF duration.
14. The method of item 12 or item 13, further comprising:
   determining, via the controller, at least one maximum peak power corresponding to the load pattern.
15. The method of any of items 12-14, wherein each pulsing train is followed by a non-pulsing train associated with zero current between the resistive load and the at least one DUT, and:
   wherein receiving, via a user interface, control input from a user includes receiving:
   a second ON duration corresponding to each pulsing train;
      and
   a second OFF duration corresponding to each non-pulsing train.
16. The method of any of items 12-15, wherein the at least one DUT includes at least one of an uninterruptible power supply (UPS) or a power distribution unit (PDU).
17. The method of any of items 12-16, wherein the at least one DUT is associated with a data center environment and includes a cooling system configured for thermal management of the data center environment.
18. The method of any of items 12-17, wherein the controller further includes a memory configured for storage of a plurality of customized load profiles, and wherein receiving control input from a user includes:
   receiving a selection of the desired load profile from among the plurality of customized load profiles.
19. The method of any of items 12-18, wherein receiving control input from a user includes receiving at least one adjustment by the user of a control parameter corresponding to the desired load profile.
20. The method of any of items 12-19, further comprising:
   presenting to the user, via a display unit operatively coupled to the controller, one or more of:
   a waveform corresponding to the generated load pattern;
      or
   the set of control parameters corresponding to the desired load profile.

## Claims

1. A system for pulsing load simulation, comprising:
at least one device under test, 'DUT', installable between a power source and a resistive load;
at least one static switching device installable between the at least one DUT and the resistive load;
a user interface configured to receive, from a user, control input associated with a desired load profile,
the desired load profile including at least one pulsing train, each pulsing train comprising a sequence of ON stages alternating with OFF stages, each ON stage associated with a maximum current between the resistive load and the at least one DUT and each OFF stage associated with a minimum current between the resistive load and the at least one DUT,
and
the control input including a set of control parameters including at least a first ON duration corresponding to each ON stage and a first OFF duration corresponding to each OFF stage;
and
a controller including at least one processor and configured to:
generate a load pattern based on the control input;
and
drive the at least one static switching device to reproduce the load pattern.

2. The system of Claim 1, wherein at least one of the first ON duration or the first OFF duration is associated with a count of voltage phase periods comprising the first ON duration or first OFF duration.

3. The system of Claim 1 or Claim 2, wherein:
each pulsing train is followed by a non-pulsing train associated with zero current between the resistive load and the at least one DUT,
and
wherein the set of control parameters includes:
a second ON duration corresponding to each pulsing train;
and
a second OFF duration corresponding to each non-pulsing train.

4. The system of any preceding Claim, wherein the controller is configured to determine at least one peak of power associated with the load pattern, and optionally wherein the at least one peak includes a sequence of peaks.

5. The system of any preceding Claim, wherein the at least one DUT includes at least one of an uninterruptible power supply, 'UPS' or a power distribution unit, 'PDU'.

6. The system of any preceding Claim, wherein the at least one DUT is associated with a data center environment and includes a cooling system configured for thermal management of the data center environment.

7. The system of any preceding Claim, wherein the controller further includes a memory configured for storage of a plurality of customized load profiles;
and
wherein the control input corresponds to a selection of the desired load profile from among the plurality of customized load profiles, and optionally:
wherein the control input includes at least one adjustment of a control parameter corresponding to the selected customized load profile.

8. The system of any preceding Claim, wherein the control input includes at least one control parameter set by the user.

9. The system of any preceding Claim, further comprising:
at least one display unit operatively coupled to the controller, the at least one display unit configured to present to the user one or more of:
a waveform corresponding to the generated load pattern;
or
a control parameter corresponding to the generated load pattern.

10. A method for pulsing load simulation, the method comprising:
providing a power source, a resistive load, and at least one device under test, 'DUT', disposed between the power source and the resistive load;
providing at least one static switching device disposed between the at least one DUT and the resistive load;
receiving, via a user interface, control input from a user, the control input associated with a desired load profile, the desired load profile including at least one pulsing train,
each pulsing train comprising a sequence of ON stages alternating with OFF stages, each ON stage associated with a maximum current between the resistive load and the at least one DUT and each OFF stage associated with a minimum current between the resistive load and the at least one DUT,
and
the control input including a set of control parameters including at least a first ON duration corresponding to each ON stage and a first OFF duration corresponding to each OFF stage;
generating, via a controller, a load pattern based on the control input;
and
reproducing the load pattern via the controller by driving the at least one static switching device to switch the resistive load on and off.

11. The method of Claim 10, wherein at least one of the first ON duration or the first OFF duration is associated with a count of voltage phase periods comprising the first ON duration or first OFF duration, and/or wherein the method further comprises determining, via the controller, at least one maximum peak power corresponding to the load pattern.

12. The method of Claim 10 or Claim 11, wherein each pulsing train is followed by a non-pulsing train associated with zero current between the resistive load and the at least one DUT, and:
wherein receiving, via a user interface, control input from a user includes receiving:
a second ON duration corresponding to each pulsing train;
and
a second OFF duration corresponding to each non-pulsing train.

13. The method of any of Claims 10-12, wherein the at least one DUT includes at least one of an uninterruptible power supply, 'UPS', or a power distribution unit, 'PDU', and/or wherein the at least one DUT is associated with a data center environment and includes a cooling system configured for thermal management of the data center environment.

14. The method of any of Claims 10-13, wherein the controller further includes a memory configured for storage of a plurality of customized load profiles, and wherein receiving control input from a user includes:
receiving a selection of the desired load profile from among the plurality of customized load profiles; and/or
receiving at least one adjustment by the user of a control parameter corresponding to the desired load profile.

15. The method of any of Claims 10-14, further comprising:
presenting to the user, via a display unit operatively coupled to the controller, one or more of:
a waveform corresponding to the generated load pattern;
or
the set of control parameters corresponding to the desired load profile.
